# EUROPÄISCHE PATENTSCHRIFT

(11) **EP 3 776 744 B1**
(45) Veröffentlichungstag und Bekanntmachung des Hinweises auf die Patenterteilung: **26.10.2022**
(21) Anmeldenummer: 19714472.8
(22) Anmeldetag: 05.04.2019
(51) Int. Cl.: H01R 12/52, H01R 4/02, H05K 1/14, H05K 3/36

(54) **LEITERPLATTENANORDNUNG**
PRINTED CIRCUIT BOARD ASSEMBLY
ENSEMBLE CARTE DE CIRCUIT IMPRIMÉ

(30) Priorität: 11.04.2018 BE 201805245
(43) Veröffentlichungstag der Anmeldung: 17.02.2021
(73) Patentinhaber: Phoenix Contact GmbH & Co. KG, 32825 Blomberg (DE)
(72) Erfinder: SCHÄFERTÖNS, Werner, 32657 Lemgo (DE)
(74) Vertreter: Patentship Patentanwaltsgesellschaft mbH
(86) Internationale Anmeldenummer: PCT/EP2019/058724
(87) Internationale Veröffentlichungsnummer: WO 2019/197300

(56) Entgegenhaltungen:
- WO-A1-95/06344
- US-A- 5 734 555

## Beschreibung

Die vorliegende Erfindung betrifft eine Anordnung von Leiterplatten, insbesondere eine Anordnung von Leiterplatten, die eine elektrische Verbindung der Leiterplatten ermöglicht.

In der WO 95/06344 A1 ist ein Matrixverbindungssystem mit mindestens zwei Leiterplatten offenbart.

In der US 5 734 555 A ist ein elektronisches Gehäuse für eine integrierte Schaltung offenbart.

In elektrischen Geräten wird für gewöhnlich eine Vielzahl von mit unterschiedlichen Bauteilen bestückten Leiterplatten verbaut. Häufig tritt hierbei die Problematik auf, die verschiedenen Leiterplatten möglichst gesichert im Inneren des Geräts zu verbauen und dabei diese möglichst platzsparend anzuordnen. Je nach Ausgestaltung der Leiterplatten und des zur Verfügung stehenden Platzes im Inneren des elektrischen Geräts ist es in diesem Zusammenhang häufig vorteilhaft, die Leiterplatten in einer vertikalen, planparallelen Anordnung in Gestalt eines Aufeinanderstapelns der einzelnen Leiterplatten anzuordnen. Dies wird für gewöhnlich über Sandwichleisten bewirkt. Sandwichleisten bieten in diesem Zusammenhang den Vorteil, dass die zu verbauenden Leiterplatten über die Sandwichleiste strukturell miteinander verbunden werden können und so eine strukturell sichere Anordnung der Leiterplatten erzielt werden kann. Darüber hinaus bietet die Sandwichleiste ebenfalls eine elektrische Verbindung der zueinander angeordneten Leiterplatten, sodass auf eine zusätzliche elektrische Verbindung der mittels der Sandwichleiste miteinander verbundenen Leiterplatten verzichtet werden kann. Sandwichleisten sind im Stand der Technik bekannt und gewöhnlicher Weise aus einer Vielzahl von elektrischen Kontaktstiften gebildet, die über einen elektrisch isolierenden Grundkörper in Einzel- oder Doppelreihen angeordnet sind, und oberhalb und unterhalb des Grundkörpers elektrische Kontakte zur Verbindung mit den jeweiligen Leiterplatten aufweisen. Über die rigide Struktur der Kontaktstifte ist die Sandwichleiste in der Lage, neben einer elektrischen Verbindung zwischen den anzuordnenden Leiterplatten auch eine strukturell sichere Anordnung der Leiterplatten bereitzustellen, welche die Leiterplatten fest miteinander verbindet. Nachteilig an herkömmlichen Sandwichleisten ist jedoch der hohe Platzbedarf, der dadurch entsteht, dass der zwischen den Leiterplatten angeordnete Grundkörper der Sandwichleiste nicht gestattet, die Leiterplatten beliebig nah aneinander anzuordnen.

Es ist daher die Aufgabe der vorliegenden Erfindung, eine verbesserte Anordnung zur elektrischen Verbindung von Leiterplatten bereitzustellen.

Diese Aufgabe wird durch die Merkmale des unabhängigen Anspruchs 1 gelöst. Vorteilhafte Ausführungsformen der Erfindung sind Gegenstand der abhängigen Ansprüche, der Beschreibung sowie der beiliegenden Figuren.

Die Erfindung basiert auf der Erkenntnis, dass die obige Aufgabe durch eine Anordnung zur elektrischen Verbindung von Leiterplatten gelöst wird, die vorsieht, zwei Leiterplatten mittels einer Lötverbindung aufeinander gestapelt elektrisch miteinander zu verbinden.

Gemäß einem Aspekt der vorliegenden Erfindung umfasst die Leiterplattenanordnung:
eine erste Leiterplatte mit einer ersten Oberfläche und einer der ersten Oberfläche abgewandten zweiten Oberfläche, einer Vielzahl von ersten elektrischen Anschlüssen und einer Vielzahl von elektrischen Kontaktstiften, welche von einer Vielzahl von ersten elektrischen Anschlüssen aufgenommen ist und die erste Leiterplatte durchsetzt, wobei erste Enden der Kontaktstifte auf der zweiten Oberfläche durch Löterhebungen elektrisch kontaktiert sind, sowie mit ersten elektrischen Kontakten, welche auf der zweiten Oberfläche angeordnet sind; und
eine zweite Leiterplatte, mit einer ersten Oberfläche und einer der ersten Oberfläche abgewandten zweiten Oberfläche, wobei in der zweiten Oberfläche eine Vielzahl von Sacklöchern für die Aufnahme der ersten Enden der Kontaktstifte gebildet ist, und wobei die zweite Leiterplatte auf der zweiten Oberfläche zweite elektrische Kontakte aufweist;
wobei die erste Leiterplatte und die zweite Leiterplatte mit ihren zweiten Oberflächen derart zusammengeführt sind, dass die ersten Enden der Kontaktstifte in die Sacklöcher hineinreichen, und dass die ersten elektrischen Kontakte die zweiten elektrischen Kontakte elektrisch kontaktieren.

Die erfindungsgemäße Leiterplattenanordnung sieht eine vertikale Anordnung zweier Leiterplatten vor. Die Leiterplattenanordnung umfasst hierzu eine erste Leiterplatte und eine zweite Leiterplatte, die jeweils eine erste Oberfläche und eine zweite Oberfläche aufweisen und dazu geeignet sind, mit einer Vielzahl von Bauteilen bestückt zu werden. Die Bauteile, die an den ersten und zweiten Leiterplatten anzuordnen sind, insbesondere eine Vielzahl von Kontaktstiften, werden jeweils an den ersten Oberflächen der ersten und zweiten Leiterplatten angeordnet.

Die Kontaktstifte der Vielzahl von Kontaktstiften, die an der ersten Leiterplatte angeordnet und mit dieser elektrisch verbunden ist, durchdringen die erste Leiterplatte derart, dass erste Enden der Kontaktstifte über die zweite Oberfläche der ersten Leiterplatte hinausragen, und sind mit der ersten Leiterplatte über Löterhebungen elektrisch verbunden.

Zur elektrischen Verbindung der ersten und zweiten Leiterplatten miteinander weisen die ersten und zweiten Leiterplatten erste und zweite elektrische Kontakte auf, wobei die ersten elektrischen Kontakte ausschließlich an der zweiten Oberfläche der ersten Leiterplatte und die zweiten elektrischen Kontakte ausschließlich an der zweiten Oberfläche der zweiten Leiterplatte ausgebildet sind.

Die Leiterplattenanordnung wird dadurch realisiert, dass die ersten und zweiten Leiterplatten jeweils mit ihren zweiten Oberflächen zusammengeführt werden, bis eine elektrische Kontaktierung der ersten elektrischen Kontakte der ersten Leiterplatte mit den zweiten elektrischen Kontakten der zweiten Leiterplatte hergestellt werden kann. Vorzugsweise werden hierzu die ersten und zweiten Leiterplatten so nah aneinander geführt, dass eine Berührung der beiden zweiten Oberflächen der ersten und zweiten Leiterplatten erreicht wird.

Die zweite Leiterplatte weist ferner an ihrer zweiten Oberfläche eine Vielzahl von Sacklöchern auf, die die ersten Enden der durch die erste Leiterplatte hindurch verlaufenden und über die zweite Oberfläche der ersten Leiterplatte hinausragenden Kontaktstifte aufnehmen, um so zu ermöglichen, dass bei einer Anordnung der ersten und zweiten Leiterplatten zur erfindungsgemäßen Leiterplattenanordnung eine Berührung der zweiten Oberflächen der ersten und zweiten Leiterplatten realisierbar ist.

Über die Kontaktierung zwischen den ersten elektrischen Kontakten der ersten Leiterplatte und den zweiten elektrischen Kontakten der zweiten Leiterplatte ist eine elektrische Verbindung zwischen den ersten und zweiten Leiterplatten hergestellt.

Indem die ersten Enden der durch die erste Leiterplatte hindurch verlaufenden Kontaktstifte, die an der zweiten Oberfläche der ersten Leiterplatte hervorstehen, durch die an der zweiten Oberfläche der zweiten Leiterplatte ausgebildeten Sacklöcher aufgenommen werden, wird eine Leiterplattenanordnung erzielt, die einen ungenutzten Raum zwischen den zwei zueinander angeordneten Leiterplatten minimieren und vorzugsweise vollständig eliminieren kann, sodass eine Leiterplattenanordnung realisierbar ist, die eine minimale vertikale Ausdehnung aufweist. Die vertikale Richtung ist in diesem Zusammenhang die Normalenrichtung der ersten und zweiten Oberflächen der ersten und zweiten Leiterplatten, wenn diese horizontal und planparallel zueinander angeordnet sind.

Nach einer Ausführungsform sind die ersten elektrischen Kontakte mit den zweiten elektrischen Kontakten elektrisch fest verbunden, insbesondere verlötet.

Erfindungsgemäß ist die elektrische Verbindung zwischen den ersten elektrischen Kontakten der ersten Leiterplatte und den zweiten elektrischen Kontakten der zweiten Leiterplatte eine feste elektrische Verbindung, die selbst durch eine extern auf die ersten und zweiten Leiterplatten einwirkende Kraft nicht leicht gelöst werden kann. Vorzugsweise ist die feste elektrische Verbindung zwischen den ersten und zweiten elektrischen Kontakten eine Lötverbindung. Die Lötverbindung gewährleistet eine strukturelle Festigkeit der Verbindung der ersten und zweiten elektrischen Kontakte und sorgt für eine leistungsfähige elektrische Verbindung der ersten und zweiten Leiterplatten. Die Fertigung der Lötverbindung, sprich der Lötvorgang, kann ferner maschinell vorgenommen werden, sodass die Realisierung der elektrischen Verbindung der ersten und zweiten Leiterplatten problemlos und Zeit sparend in den Fertigungsprozess der Leiterplattenanordnung integriert werden kann.

Nach einer Ausführungsform stellen die Lötverbindungen zwischen den ersten elektrischen Kontakten und den zweiten elektrischen Kontakten eine elektrische Verbindung und eine strukturelle Verbindung der ersten und zweiten Leiterplatten bereit.

Die Lötstellen an den ersten und zweiten elektrischen Kontakten der ersten und zweiten Leiterplatten dienen erfindungsgemäß nicht nur zur elektrischen Verbindung der ersten und zweiten Leiterplatten, sondern stellen darüber hinaus eine strukturelle Verbindung der ersten und zweiten Leiterplatten bereit und sorgen dafür, dass die ersten und zweiten Leiterplatten fest miteinander fixiert sind. Hierdurch kann der Einsatz von zusätzlichen strukturellen Verbindungsmitteln, die ansonsten für eine strukturelle Verbindung der ersten und zweiten Leiterplatten benötigt würden, vermieden werden. Damit wird wiederum nicht nur eine Vereinfachung des Fertigungsprozesses der Leiterplattenanordnung erreicht, indem die elektrische wie auch strukturelle Verbindung der ersten und zweiten Leiterplatten mit dem Aufbringen der Lötstellen an den ersten und zweiten elektrischen Kontakten in einem Arbeitsschritt bewirkt werden kann. Sondern es ist ebenfalls eine raumeffizientere Ausgestaltung der Leiterplattenanordnung möglich, da keine separaten strukturellen Verbindungsmittel an den Leiterplatten angebracht werden müssen und die Flächen der Leiterplatten folglich effizienter zur Bestückung mit Bauteilen genutzt werden können. Ferner nehmen die Lötstellen einen sehr geringen Platz auf der Leiterplatte ein, da sie insbesondere mit einer vergleichsweise geringen Stärke beziehungsweise Dicke ausgebildet werden, wodurch zusätzlich eine erfindungsgemäß zu erzielende geringe vertikale Ausdehnung der Leiterplattenanordnung möglich ist.

Nach einer Ausführungsform sind die ersten elektrischen Kontakte als Kontaktausnehmungen, insbesondere Lötkelche, ausgebildet, die geeignet sind, ein Lot aufzunehmen.

Die als Kontaktausnehmungen beziehungsweise Lötkelche ausgebildeten ersten elektrischen Kontakte sind geeignet, eine substantielle Menge an Lot aufzunehmen und für die Lötstellen bereitzustellen Die substantielle Menge an Lot, die somit für jede einzelne Lötstelle durch die ersten elektrischen Kontakte zur Verfügung steht, bewirkt, dass eine möglichst robuste und leistungsfähige elektrische Verbindung der ersten und zweiten Leiterplatten erreicht werden kann. Ferner kann hierdurch eine strukturelle Festigkeit der durch die Lötstellen bereitgestellten strukturellen Verbindung der ersten und zweiten Leiterplatten erzielt werden, die den mechanischen Beanspruchungen der Leiterplattenanordnung standhalten kann. Auf die Verwendung zusätzlicher struktureller Verbindungsmittel kann folglich verzichtet und die strukturelle Verbindung der ersten und zweiten Leiterplatten ausschließlich durch die Lötstellen an den ersten und zweiten elektrischen Kontakten bewirkt werden. Vorzugsweise sind die ersten elektrischen Kontakte aus elektrisch leitendem Material, besonders bevorzugt aus einem metallischen Material ausgebildet.

Nach einer Ausführungsform sind die zweiten elektrischen Kontakte als Kontaktflächen, insbesondere Lötpads, ausgebildet, auf die ein Lot auftragbar ist.

Durch die Ausbildung der zweiten elektrischen Kontakte als Kontaktflächen, insbesondere Lötpads, wird erreicht, dass die zweiten elektrischen Kontakte mit dem von den ersten elektrischen Kontakten aufgenommenen und zur Verbindung bereitgestellten Lot eine elektrische Verbindung eingehen können. Vorzugsweise sind die zweiten elektrischen Kontakte aus elektrisch leitenden Material, besonders bevorzugt aus einem metallischen Material ausgebildet.

Nach einer Ausführungsform sind die ersten elektrischen Kontakte und die zweiten elektrischen Kontakte durch die Zusammenführung der zweiten Oberflächen der ersten Leiterplatte und der zweiten Leiterplatte elektrisch verbindbar.

Durch Zusammenführen der zweiten Oberflächen der ersten und zweiten Leiterplatten können die als Kontaktflächen ausgebildeten zweiten elektrischen Kontakte in das durch die als Kontaktausnehmungen ausgestalteten ersten elektrischen Kontakte bereitgestellte Lot eintauchen und so eine robuste elektrische und starke strukturelle Verbindung zwischen den ersten und zweiten Leiterplatten bereitstellen. Durch die Ausbildung der ersten elektrischen Kontakte als Kontaktausnehmungen und die Ausbildung der zweiten elektrischen Kontakte als Kontaktflächen kann zum einen eine substantielle Menge an Lot zur Verbindung genutzt werden und zum anderem durch die vollständige Benetzung der ersten und zweiten Kontakte mit Lot eine möglichst große Kontaktfläche zwischen den ersten und zweiten Kontakten und dem zur Verbindung verwendeten Lot und damit eine möglichst starke elektrische und strukturelle Verbindung der ersten und zweiten elektrischen Kontakte erzielt werden. Ferner kann durch die Kombination von Kontaktausnehmung und in die Kontaktausnehmung hineinreichende Kontaktfläche zur Erreichung einer derart starken Verbindung eine entsprechend dick auf den zweiten Oberflächen der ersten und zweiten Leiterplatten aufgetragenen Lotschicht vermieden werden, die einen ungewünschten Zwischenraum zwischen den ersten und zweiten Leiterplatten bewirken würde.

Nach einer Ausführungsform ist die Vielzahl von ersten elektrischen Anschlüssen als eine Vielzahl von Durchgangsbohrungen, insbesondere eine Vielzahl von Lötaugen, ausgebildet und geeignet, eine Vielzahl von Bauteilen, insbesondere die Kontaktstifte, aufzunehmen und elektrisch zu verbinden.

Durch die ersten elektrischen Anschlüsse kann eine elektrische und strukturelle Verbindung der Kontaktstifte mit der ersten Leiterplatte erzielt werden, indem die ersten elektrischen Anschlüsse ausgebildet sind, die Kontaktstifte derart aufzunehmen, dass diese durch die erste Leiterplatte hindurch verlaufen, und die Kontaktstifte ferner mit der ersten Leiterplatte elektrisch zu verbinden. Vorzugsweise sind die ersten elektrischen Anschlüsse als Lötaugen ausgebildet.

Nach einer weiteren Ausführungsform kann durch die ersten elektrischen Kontakte eine elektrische und strukturelle Verbindung der Kontaktstifte mit der zweiten Leiterplatte erzielt werden.

Nach einer weiteren Ausführungsform kann durch eine Verbindung zwischen den ersten elektrischen Kontakten und den zweiten elektrischen Kontakten eine elektrische und strukturelle Verbindung der Kontaktstifte mit der zweiten Leiterplatte erzielt werden.

Nach einer Ausführungsform entspricht die jeweilige Position der Vielzahl von Sacklöchern an der zweiten Oberfläche der zweiten Leiterplatte der jeweiligen Position der Vielzahl von ersten elektrischen Anschlüssen an der zweiten Oberfläche der ersten Leiterplatte.

Bei planparalleler Anordnung der zweiten Oberflächen der ersten und zweiten Leiterplatten kann die Vielzahl der an der zweiten Oberfläche der zweiten Leiterplatte ausgebildeten Sacklöcher mit der Vielzahl der an der ersten Leiterplatte ausgebildeten ersten elektrischen Anschlüsse deckungsgleich orientiert werden. Hierdurch wird gewährleistet, dass bei Zusammenführen der zweiten Oberflächen der ersten und zweiten Leiterplatten die über die zweite Oberfläche der ersten Leiterplatte herausragenden ersten Enden der elektrischen Kontaktstifte in die Sacklöcher hineinreichen und von diesen aufgenommen werden.

Nach einer Ausführungsform ist die Vielzahl von Sacklöchern aus einem elektrisch isolierenden Material ausgebildet.

Durch die Ausbildung der Vielzahl von Sacklöchern in der zweiten Oberfläche der zweiten Leiterplatte aus einem elektrisch isolierenden Material wird vermieden, dass bei Aufnahme der ersten Enden der Kontaktstifte der Vielzahl von Kontaktstiften der ersten Leiterplatte durch die Vielzahl von Sacklöchern eine direkte elektrische Verbindung der Kontaktstifte der ersten Leiterplatte mit Bauteilen der zweiten Leiterplatte stattfinden kann, was einen fehlerfreien Betrieb der ersten und zweiten Leiterplatten stören und verhindern könnte.

Nach einer Ausführungsform weist die zweite Leiterplatte eine Vielzahl von zweiten elektrischen Anschlüssen auf, die ausgebildet ist, eine Vielzahl von Bauteilen, insbesondere eine Stiftleiste zur Systemverkabelung, aufzunehmen und elektrisch zu verbinden.

Die Vielzahl von zweiten elektrischen Anschlüssen ist vorzugsweise als eine Vielzahl von Durchgangsbohrungen oder Sacklöchern, insbesondere Lötaugen ausgebildet, die geeignet ist, die Vielzahl von Bauteilen, insbesondere die Stiftleiste, aufzunehmen und elektrisch zu verbinden.

Nach einer weiteren Ausführungsform sind die ersten elektrischen Kontakte als Kontaktausnehmungen und die zweiten elektrischen Kontakte als Kontaktflächen ausgebildet und dienen zur Verbindung der ersten und zweiten Leiterplatten.

Nach einer Ausführungsform sind die ersten und zweiten Oberflächen der ersten und zweiten Leiterplatten die Flächen der Leiterplatten, die den größten Flächeninhalt aufweisen.

Erfindungsgemäß wird die Leiterplattenanordnung durch ein Aufeinanderstapeln der ersten und zweiten Leiterplatten realisiert. Dies wird ferner dadurch erreicht, dass beim Aufeinanderstapeln der ersten und zweiten Leiterplatten diese jeweils mit ihren zweiten Oberflächen einander zugewandt orientiert sind. Dies bewirkt, dass eine möglichst platzsparende Anordnung der Leiterplatten erzielt werden kann, indem die zweiten Oberflächen der ersten und zweiten Leiterplatten möglichst nah, vorzugsweise aufeinander aufliegend, zusammengeführt werden. Somit wird die erfindungsgemäße Leiterplattenanordnung als eine platzsparende vertikale Anordnung der ersten und zweiten Leiterplatten realisiert.

Nach einer Ausführungsform sind die ersten elektrischen Kontakte der ersten Leiterplatte und die zweiten elektrischen Kontakte der zweiten Leiterplatte zueinander deckungsgleich angeordnet.

Vorzugsweise weisen die ersten und zweiten Leiterplatten eine identische Anzahl an ersten und zweiten elektrischen Kontakten auf, die jeweils an den ersten und zweiten Leiterplatten an einander entsprechenden Stellen ausgebildet sind, sodass die ersten und zweiten elektrischen Kontakte durch Zusammenfügen der beiden zweiten Oberflächen der ersten und zweiten Leiterplatten exakt übereinanderliegend angeordnet werden können. Damit wird erreicht, dass durch einen möglichst hohen Deckungsgrad der ersten und zweiten elektrischen Kontakten zueinander eine möglichst starke Verbindung erreicht wird, indem durch die deckungsgleiche Anordnung die Kontaktfläche zwischen ersten und zweiten Kontakten und dem zur Verbindung genutzten Lot maximiert wird.

Nach einer Ausführungsform sind die ersten elektrischen Kontakte am Rand der zweiten Oberfläche der ersten Leiterplatte und die zweiten elektrischen Kontakte am Rand der zweiten Oberfläche der zweiten Leiterplatte ausgebildet.

Die Ausbildung der ersten und zweiten elektrischen Kontakte jeweils an den Rändern der ersten und zweiten Leiterplatten bewirkt zum einen eine Vereinfachung des Lötvorgangs beziehungsweise des Aufbringens der Lötstellen an den ersten und zweiten elektrischen Kontakten, da die an den Rändern der Leiterplatten ausgebildeten ersten und zweiten elektrischen Kontakte gegenüber im Flächeninneren der ersten und zweiten Leiterplatten ausgebildeten Kontakten einen vereinfachten Zugang bedeuten. Ferner wird durch die Ausbildung der ersten und zweiten elektrischen Kontakte an den Rändern der ersten und zweiten Leiterplatten erreicht, dass das Flächeninnere der Leiterplatten ausschließlich für die Bestückung mit elektronischen Bauteilen, insbesondere den Kontaktstiften und der Stiftleiste, genutzt werden kann, was wiederum zu einer möglichst platzeffizienten Lösung der erfindungsgemäßen Leiterplattenanordnung beiträgt.

Nach einer Ausführungsform sind die erste Leiterplatte und die zweite Leiterplatte zur elektrischen Verbindung derart zusammengeführt, dass die zweiten Oberflächen der ersten und zweiten Leiterplatten aufeinander aufliegen.

Erfindungsgemäß stellt die Leiterplattenanordnung der vorliegenden Erfindung eine vertikale Anordnung der ersten und zweiten Leiterplatten mit einer möglichst geringen vertikalen Ausdehnung dar. Durch das Zusammenfügen der zweiten Oberflächen der ersten und zweiten Leiterplatten bis zu einem vollständigen Aufliegen der ersten und zweiten Leiterplatten kann ein ungenutzter Zwischenraum zwischen den ersten und zweiten Leiterplatten vermieden und folglich eine Anordnung der ersten und zweiten Leiterplatten mit minimaler vertikaler Ausdehnung erreicht werden.

Nach einer Ausführungsform sind die erste Leiterplatte und die zweite Leiterplatte zueinander deckungsgleich angeordnet.

Vorteilhafterweise weisen die ersten und zweiten Leiterplatten identische Ausmaße auf. Hierdurch wird zum einen die Fertigung vereinfacht, da identische Komponenten verwendet werden können, und zum anderen ist die erfindungsgemäße Leiterplattenanordnung auch in horizontaler Richtung in minimaler Ausdehnung fertigbar.

Nach einer Ausführungsform sind die Kontaktstifte mit der ersten Leiterplatte und die Stiftleiste mit der zweiten Leiterplatte jeweils durch Lötverbindungen elektrisch verbunden.

Nach einer Ausführungsform sind die die vertikalen Ausmaße der Anordnung durch Dicken der ersten und zweiten Leiterplatten bestimmt.

Durch das Zusammenführen der zweiten Oberflächen der ersten und zweiten Leiterplatten zur elektrischen und strukturellen Verbindung durch die Lötstellen an den ersten und zweiten elektrischen Kontakten und zur Realisierung einer Leiterplattenanordnung wird vorzugsweise erreicht, dass die zweiten Oberflächen der ersten und zweiten Leiterplatten aufeinander aufliegen und somit ein Zwischenraum zwischen den ersten und zweiten Leiterplatten vermieden wird. Die vertikale Ausdehnung der Leiterplattenanordnung ist damit primär von der vertikalen Ausdehnung der jeweiligen ersten und zweiten Leiterplatten abhängig, wobei hierbei die an den ersten und zweiten Leiterplatten verbauten Bauteile und deren vertikalen Ausmaße nicht zu der vertikalen Ausdehnung der Leiterplattenanordnung hinzugerechnet wird. Die erfindungsgemäße Leiterplattenanordnung ermöglicht somit gegenüber herkömmlichen Leiterplattenanordnungen, die beispielsweise über aus dem Stand der Technik bekannte Sandwichleisten realisiert sind, eine speziell in vertikaler Richtung platzeffiziente Anordnung von Leiterplatten.

Weitere Ausführungsbeispiele werden Bezug nehmend auf die beiliegenden Figuren erläutert. Es zeigen:
Fig. 1 eine schematische Seitenansicht einer Leiterplattenanordnung nach einem Ausführungsbeispiel der vorliegenden Erfindung;
Fig. 2A eine schematische Draufsicht einer zweiten Leiterplatte einer Leiterplattenanordnung nach einem Ausführungsbeispiel der vorliegenden Erfindung;
Fig. 2B eine schematische Draufsicht einer ersten Leiterplatte einer Leiterplattenanordnung nach einem Ausführungsbeispiel der vorliegenden Erfindung; und
Fig. 2C eine schematische Draufsicht einer Leiterplattenanordnung nach einem Ausführungsbeispiel der vorliegenden Erfindung, wobei die erste Leiterplatte auf der zweiten Leiterplatte aufliegt, und wobei die ersten und zweiten Leiterplatten über Lötungen an den Kontaktausnehmungen der ersten Leiterplatte und den Kontaktflächen der zweiten Leiterplatte elektrisch miteinander verbunden sind.

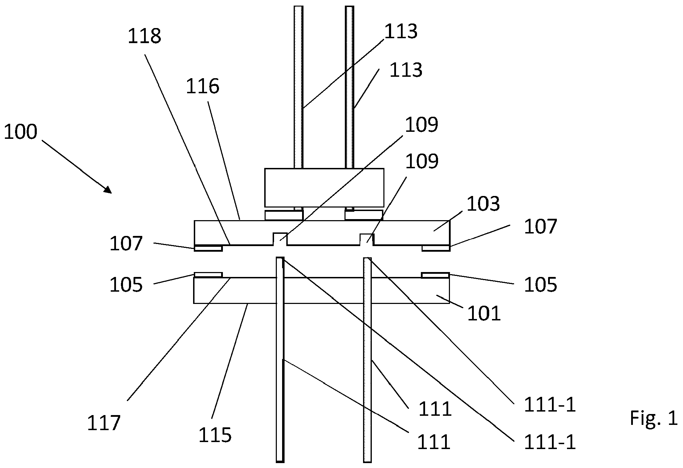

Gemäß Fig. 1 umfasst eine Leiterplattenanordnung 100 nach einem bevorzugten Ausführungsbeispiel der vorliegenden Erfindung eine erste Leiterplatte 101 mit einer ersten Oberfläche 115 und einer zweiten Oberfläche 117 und eine zweite Leiterplatte 103 mit einer ersten Oberfläche 116 und einer zweiten Oberfläche 118.

Die erste Leiterplatte 101 umfasst ferner erste elektrische Kontakte 105, die an der zweiten Oberfläche 117 der ersten Leiterplatte 101 ausgebildet sind. Vorzugsweise sind die ersten elektrischen Kontakte 105 am Rand der zweiten Oberfläche 117 der ersten Leiterplatte 101 ausgebildet. Die erste Leiterplatte 101 umfasst zusätzlich eine Vielzahl von Kontaktstiften 111, die durch die erste Leiterplatte 101 hindurch verlaufen. Die Kontaktstifte 111 weisen wiederum erste Enden 111-1 auf, wobei die Kontaktstifte 111 derart durch die erste Leiterplatte 101 hindurch verlaufen, dass die ersten Enden 111-1 der Kontaktstifte 111 über die zweite Oberfläche 117 der ersten Leiterplatte 101 hinausragen.

Die zweite Leiterplatte 103 weist eine Stiftleiste 113 auf, die an der ersten Oberfläche 116 der zweiten Leiterplatte 103 ausgebildet und mit dieser elektrisch verbunden ist. Die zweite Leiterplatte 103 weist ferner eine Vielzahl von Sacklöchern 109 auf, die an der zweiten Oberfläche 118 der zweiten Leiterplatte 103 ausgebildet ist. Die Position der Vielzahl von Sacklöchern 109 an der zweiten Oberfläche 118 der zweiten Leiterplatte 103 entspricht der Position der Vielzahl von ersten Enden 111-1 der Vielzahl von Kontaktstiften 111 an der zweiten Oberfläche 117 der ersten Leiterplatte 101. Darüber hinaus weist die zweite Leiterplatte 103 eine Vielzahl von zweiten elektrischen Kontakten 107 auf, die an der zweiten Oberfläche 118 der zweiten Leiterplatte 103 ausgebildet ist. Wie in Fig. 1 gezeigt, entspricht die Position der zweiten elektrischen Kontakte 107 an der zweiten Oberflächen 118 der zweiten Leiterplatte 103 der Position der ersten elektrischen Kontakte 105 an der zweiten Oberflächen 117 der ersten Leiterplatte 101.

Vorzugsweise sind die ersten elektrischen Kontakte 105 als Kontaktausnehmungen in der ersten Leiterplatte 101, insbesondere als Lötkelche, ausgestaltet. Aus darstellerischen Gründen sind die ersten elektrischen Kontakte 105 in der Fig. 1 lediglich schematisch dargestellt, sodass die Ausgestaltung der ersten elektrischen Kontakte als Kontaktausnehmungen bzw. Lötkelche nicht explizit illustriert ist.

Fig. 1 zeigt die erfindungsgemäße Leiterplattenanordnung in einem nicht verbundenen Zustand. Zur Verbindung der ersten und zweiten Leiterplatten 101, 103 werden die erste Leiterplatte 101 und die zweite Leiterplatte 103 mit ihren zweiten Oberflächen 117, 118 zusammengeführt, sodass eine elektrische Kontaktierung der ersten elektrischen Kontakte 105 der ersten Leiterplatte 101 mit den zweiten elektrischen Kontakten 107 der zweiten Leiterplatte 103 ermöglicht ist. Beim Zusammenführen der beiden zweiten Oberflächen 117, 118 der ersten und zweiten Leiterplatten 101, 103 reichen die an der zweiten Oberfläche 117 der ersten Leiterplatte 101 hervorstehenden ersten Enden 111-1 der durch die erste Leiterplatte 101 hindurch verlaufenden Kontaktstifte 111 in die an der zweiten Oberfläche 118 der zweiten Leiterplatte 103 ausgebildeten Sacklöcher 109 hinein und werden von diesen aufgenommen. Hierdurch wird eine weitere Annäherung der beiden zweiten Oberflächen 117, 118 der ersten und zweiten Leiterplatten 101, 103 ermöglicht.

Vorzugsweise werden die ersten und zweiten Leiterplatten 101, 103 so nah zusammengeführt, dass die beiden zweiten Oberflächen 117, 118 der ersten und zweiten Leiterplatten 101, 103 vollständig aufeinander aufliegen.

Die elektrische Verbindung der ersten elektrischen Kontakte 105 der ersten Leiterplatte 101 mit den zweiten elektrischen Kontakten 107 der zweiten Leiterplatte 103 wird vorzugsweise über eine Lötverbindung realisiert. Das Lot kann hierbei durch die als Kontaktausnehmungen bzw. Lötkelche ausgebildeten ersten elektrischen Kontakte 105 der ersten Leiterplatte 101 aufgenommen werden, sodass durch das Eintauchen der als Kontaktflächen bzw. Lötpads ausgebildeten zweiten elektrischen Kontakte 107 der zweiten Leiterplatte 103 in das von den ersten elektrischen Kontakten 105 aufgenommene Lot eine leistungsfähige elektrische Verbindung zwischen den ersten und zweiten elektrischen Kontakten 105, 107 hergestellt werden kann. Durch die substanzielle Menge an Lot, die für jede Lötverbindung zwischen ersten und zweiten elektrischen Kontakten 105, 107 verwendet wird, kann ferner eine substantielle strukturelle Stärke der jeweiligen Lötverbindungen erzielt werden, sodass die Lötverbindungen der ersten und zweiten elektrischen Kontakte 105, 107 neben der elektrischen Verbindung der ersten und zweiten Leiterplatten 101, 103 auch eine strukturelle Verbindung der ersten und zweiten Leiterplatten 101, 103 bereitstellen. Auf zusätzliche strukturelle Verbindungsmittel, die zu einer strukturellen Verbindung der ersten und zweiten Leiterplatten 101, 103 beitragen könnten, kann bei einer erfindungsgemäßen Leiterplattenanordnung verzichtet werden.

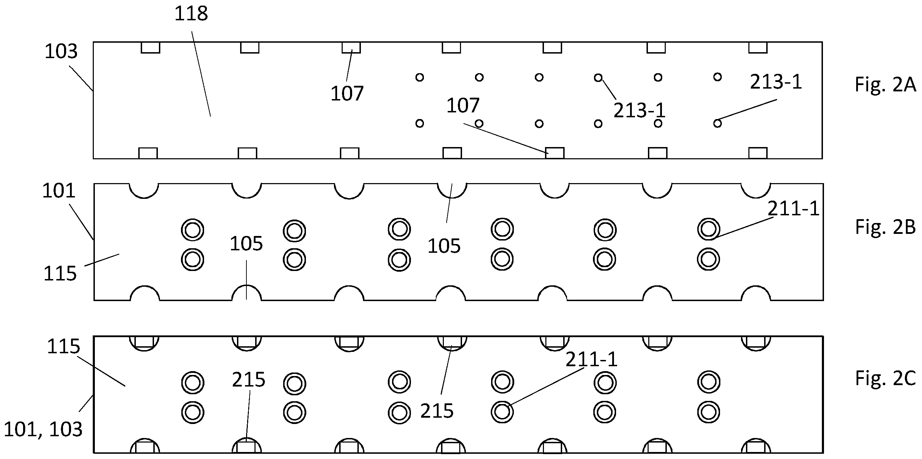

Fig. 2A ist eine schematische Draufsicht der zweiten Leiterplatte 103 gemäß einem Ausführungsbeispiel der vorliegenden Erfindung, wobei vorliegend die zweite Oberfläche 118 der zweiten Leiterplatte 103 dargestellt ist. Die zweite Leiterplatte 103 ist als eine schmale, längsgestreckte, rechteckige Platte ausgebildet und weist eine Vielzahl von zweiten elektrischen Kontakten 107 und eine Vielzahl von zweiten elektrischen Anschlüssen 213-1 auf. Eine andere als die dargestellte rechteckige Form der ersten Leiterplatte 101 ist jedoch ebenfalls möglich. Die Vielzahl von Sacklöchern 109 ist in Fig. 2A nicht dargestellt.

Die zweiten elektrischen Kontakte 107 sind an der zweiten Oberfläche 118 als Kontaktflächen bzw. Lötpads ausgebildet und jeweils an den beiden gegenüberliegenden Rändern der Längsseiten der zweiten Leiterplatte 103 angeordnet. Die zweiten elektrischen Kontakte 107 sind vorliegend als rechteckige Kontaktflächen dargestellt. Eine andere Form für die zweiten elektrischen Kontakte 107 ist aber ebenfalls möglich. Die Vielzahl von zweiten elektrischen Anschlüssen 213-1 dient zur Bestückung der Leiterplatte, sprich zur Aufnahme und elektrischen Verbindung von Bauteilen, insbesondere der Stiftleiste 113, mit der zweiten Leiterplatte 103. Die zweiten elektrischen Anschlüsse 213-1 können als Durchgangsbohrungen, Sacklöcher oder andere Anschlüsse ausgebildet sein, die es ermöglichen eine Vielzahl von elektronischen Bauteilen auf der zweiten Leiterplatte 103 anzuordnen und elektrisch zu verbinden. Vorzugsweise sind die zweiten elektrischen Kontakte 213-1 als Lötaugen ausgebildet. In Fig. 2A sind die zweiten elektrischen Anschlüsse 213-1 als eine Doppelreihe von Anschlüssen dargestellt, die geeignet ist, die Stiftleiste 113 an der zweiten Leiterplatte 103 zu befestigen und elektrisch zu verbinden. Eine andersartige Anordnung der zweiten elektrischen Anschlüsse 213-1 an der zweiten Leiterplatte 103 ist jedoch ebenfalls möglich.

Fig. 2B ist eine schematische Draufsicht der ersten Leiterplatte 101 gemäß einem Ausführungsbeispiel der vorliegenden Erfindung, wobei vorliegend die erste Oberfläche 115 der ersten Leiterplatte 101 dargestellt ist. Die erste Leiterplatte 101 ist wie die zweite Leiterplatte 103 als eine schmale, längsgestreckte, rechteckige Platte ausgebildet und weist eine Vielzahl von ersten elektrischen Kontakten 105 und eine Vielzahl von ersten elektrischen Anschlüssen 211-1 auf. Eine andere als die dargestellte rechteckige Form der ersten Leiterplatte 101 ist jedoch ebenfalls möglich.

Die ersten elektrischen Kontakte 105 sind als Kontaktausnehmungen ausgebildet und an den Rändern der beiden gegenüberliegenden Längsseiten der ersten Leiterplatte 101 angeordnet. Die halbkreisförmige Gestaltung der Kontaktausnehmungen der ersten elektrischen Kontakte 105 in Fig. 2A ist lediglich illustrativen Gründen geschuldet und soll die Form der ersten elektrischen Kontakte 105 nicht auf die in Fig. 2B und Fig. 2C gezeigte Form beschränken. Weitere von den gezeigten abweichende Ausgestaltungen der ersten elektrischen Kontakte 105 sind ebenfalls möglich. Die ersten elektrischen Kontakte 105 sind derart mit einem metallischen Material ausgebildet, dass ein elektrischer Kontakt mit den zweiten elektrischen Kontakten 107 der zweiten Leiterplatte 103 über eine Lötverbindung ermöglicht ist. Die ersten elektrischen Kontakte 105 der ersten Leiterplatte 101 sind an den Rändern der Längsseiten der ersten Leiterplatte 101 jeweils derart ausgebildet, dass die Positionen der ersten elektrischen Kontakte 105 den Positionen der zweiten elektrischen Kontakte 107 an der zweiten Leiterplatte 103 entsprechen.

Die erste Leiterplatte 101 weist ferner eine Vielzahl von ersten elektrischen Anschlüssen 211-1 auf, die in Figur 2B als eine mittig auf der ersten Leiterplatte 101 angeordnete Doppelreihe von Anschlüssen ausgebildet ist. Eine andere Anordnung, die den jeweiligen Anforderungen anderer an der ersten Leiterplatte 101 anzuordnender Bauteile entspricht, ist ebenfalls möglich. Die ersten elektrischen Anschlüsse 211-1 sind als Durchgangsbohrungen ausgebildet, mit einem metallischen Material versehen und geeignet, die Kontaktstifte 111 aufzunehmen und elektrisch zu verbinden. Vorzugsweise sind die ersten elektrischen Anschlüsse 211-1 als Lötaugen ausgebildet.

Fig. 2C zeigt die ersten und zweiten Leiterplatten 101, 103 der erfindungsgemäßen Leiterplattenanordnung 100 in einem verbundenen Zustand. Hierzu sind die erste Leiterplatte 101 und die zweite Leiterplatte 103 mit ihren zweiten Oberflächen 117, 118 zusammengefügt, sodass wie in Figur 2C gezeigt, die erste Leiterplatte 101 auf der zweiten Leiterplatte 103 aufliegt. Wie in Figur 2C gezeigt, sind die ersten und zweiten Leiterplatten 101, 103 derart übereinandergestapelt, dass die ersten und zweiten Leiterplatten 101, 103 zur Deckung gebracht sind. Eine andere Anordnung ist aber ebenfalls möglich.

Die ersten und zweiten elektrischen Kontakte 105, 107 der ersten und zweiten Leiterplatten 101, 103 sind in Fig. 2C vollständig zur Deckung gebracht, wobei eine andere Anordnung der ersten und zweiten elektrischen Kontakte 105, 107 ebenfalls möglich ist. Die vollständige Deckung der ersten und zweiten elektrischen Kontakte 105, 107 ermöglicht einen möglichst umfassenden Auftrag von Lot auf den ersten und zweiten elektrischen Kontakten 105, 107, sodass durch die auf den Kontakten gebildeten Lötstellen 215 eine möglichst leistungsfähige elektrische wie robust strukturelle Verbindung der ersten und zweiten elektrischen Kontakte 105, 107 und damit der ersten und zweiten Leiterplatten 101, 103 bewirkt werden kann.

### Bezugszeichenliste

- 100: Leiterplattenanordnung
- 101: erste Leiterplatte
- 103: zweite Leiterplatte
- 105: erster elektrischer Kontakt
- 107: zweiter elektrischer Kontakt
- 109: Sackloch
- 111: Kontaktstift
- 111-1: erstes Ende
- 113: Stiftleiste
- 115: erste Oberfläche
- 116: erste Oberfläche
- 117: zweite Oberfläche
- 118: zweite Oberfläche
- 211-1: erster elektrischer Anschluss
- 213-1: zweiter elektrischer Anschluss
- 215: Lötstelle

## Patentansprüche

1. Leiterplattenanordnung (100), mit:
einer ersten Leiterplatte (101), mit einer ersten Oberfläche (115) und einer der ersten Oberfläche (115) abgewandten zweiten Oberfläche (117), einer Vielzahl von elektrischen Kontaktstiften (111), welche von einer Vielzahl von ersten elektrischen Anschlüssen (211-1) aufgenommen ist und die erste Leiterplatte (101) durchsetzt, wobei erste Enden (111-1) der Kontaktstifte (111) auf der zweiten Oberfläche (117) durch Löterhebungen elektrisch kontaktiert sind, sowie mit ersten elektrischen Kontakten (105), welche auf der zweiten Oberfläche (117) angeordnet sind; und
einer zweiten Leiterplatte (103), mit einer ersten Oberfläche (116) und einer der ersten Oberfläche (116) abgewandten zweiten Oberfläche (118),
**dadurch gekennzeichnet, dass**
in der zweiten Oberfläche (118) eine Vielzahl von Sacklöchern (109) für die Aufnahme der ersten Enden (111-1) der Kontaktstifte (111) gebildet ist, wobei die zweite Leiterplatte (103) auf der zweiten Oberfläche (118) zweite elektrische Kontakte (107) aufweist;
wobei die erste Leiterplatte (101) und die zweite Leiterplatte (103) mit ihren zweiten Oberflächen (117, 118) derart zusammengeführt sind, dass die ersten Enden (111-1) der Kontaktstifte (111) in die Sacklöcher (109) hineinreichen, und dass die ersten elektrischen Kontakte (105) die zweiten elektrischen Kontakte (107) elektrisch kontaktieren.

2. Leiterplattenanordnung (100) nach Anspruch 1, wobei die ersten elektrischen Kontakte (105) mit den zweiten elektrischen Kontakten (107) elektrisch fest verbunden, insbesondere verlötet, sind.

3. Leiterplattenanordnung (100) nach Anspruch 2, wobei die Lötverbindungen zwischen den ersten elektrischen Kontakten (105) und den zweiten elektrischen Kontakten (107) eine elektrische Verbindung und eine strukturelle Verbindung der ersten und zweiten Leiterplatten (101, 103) bereitstellen.

4. Leiterplattenanordnung (100) nach einem der vorstehenden Ansprüche, wobei die ersten elektrischen Kontakte (105) als Kontaktausnehmungen, insbesondere Lötkelche, ausgebildet sind, die geeignet sind, ein Lot aufzunehmen.

5. Leiterplattenanordnung (100) nach einem der vorstehenden Ansprüche, wobei die zweiten elektrischen Kontakte (107) als Kontaktflächen, insbesondere Lötpads, ausgebildet sind, auf die ein Lot auftragbar ist.

6. Leiterplattenanordnung (100) nach einem der vorstehenden Ansprüche, wobei die Vielzahl von ersten elektrischen Anschlüssen (211-1) als eine Vielzahl von Durchgangsbohrungen, insbesondere eine Vielzahl von Lötaugen ausgebildet und geeignet ist, eine Vielzahl von Bauteilen, insbesondere die Kontaktstifte (111), aufzunehmen und elektrisch zu verbinden.

7. Leiterplattenanordnung (100) nach einem der vorstehenden Ansprüche, wobei die Position der Vielzahl von Sacklöchern (109) an der zweiten Oberfläche (118) der zweiten Leiterplatte (103) der Position der Vielzahl von ersten elektrischen Anschlüssen (211-1) an der zweiten Oberfläche (117) der ersten Leiterplatte (101) entspricht.

8. Leiterplattenanordnung (100) nach einem der vorstehenden Ansprüche, wobei die Vielzahl von Sacklöchern (109) aus einem elektrisch isolierenden Material ausgebildet ist.

9. Leiterplattenanordnung (100) nach einem der vorstehenden Ansprüche, wobei die zweite Leiterplatte (103) eine Vielzahl von zweiten elektrischen Anschlüssen (213-1) aufweist, die ausgebildet ist, eine Vielzahl von Bauteilen, insbesondere eine Stiftleiste (113) zur Systemverkabelung, aufzunehmen und elektrisch zu verbinden.

10. Leiterplattenanordnung (100) nach einem der vorstehenden Ansprüche, wobei die ersten und zweiten Oberflächen (115, 116, 117, 118) der ersten und zweiten Leiterplatten (101, 103) Flächen der Leiterplatten sind, die den größten Flächeninhalt aufweisen.

11. Leiterplattenanordnung (100) nach einem der vorstehenden Ansprüche, wobei die ersten elektrischen Kontakte (105) der ersten Leiterplatte (101) und die zweiten elektrischen Kontakte (107) der zweiten Leiterplatte (103) zueinander deckungsgleich angeordnet sind.

12. Leiterplattenanordnung (100) nach einem der vorstehenden Ansprüche, wobei die ersten elektrischen Kontakte (105) am Rand der zweiten Oberfläche (117) der ersten Leiterplatte (101) und die zweiten elektrischen Kontakte (107) am Rand der zweiten Oberfläche (118) der zweiten Leiterplatte (103) ausgebildet sind.

13. Leiterplattenanordnung (100) nach einem der vorstehenden Ansprüche, wobei die erste Leiterplatte (101) und die zweite Leiterplatte (103) zur elektrischen Verbindung derart zusammengeführt sind, dass die zweiten Oberflächen (117, 118) der ersten und zweiten Leiterplatten (101, 103) aufeinander aufliegen.

14. Leiterplattenanordnung (100) nach einem der vorstehenden Ansprüche, wobei die erste Leiterplatte (101) und die zweite Leiterplatte (103) zueinander deckungsgleich angeordnet sind.

15. Leiterplattenanordnung (100) nach einem der vorstehenden Ansprüche, wobei die vertikalen Ausmaße der Leiterplattenanordnung durch Dicken der ersten und zweiten Leiterplatten (101, 103) bestimmt ist.

## Claims

1. A printed circuit board assembly (100), comprising:
a first printed circuit board (101), with a first surface (115) and a second surface (117) facing away from the first surface (115), a plurality of electrical contact pins (111), which is received by a plurality of first electrical connections (211-1) and passes through the first printed circuit board (101), wherein first ends (111-1) of the contact pins (111) are electrically contacted on the second surface (117) by soldered elevations, and with first electrical contacts (105), which are arranged on the second surface (117); and
a second printed circuit board (103), with a first surface (116) and a second surface (118) facing away from the first surface (116),
**characterized in that**
in the second surface (118), a plurality of blind holes (109) for receiving the first ends (111-1) of the contact pins (111) is formed, wherein the second printed circuit board (103) comprises second electrical contacts (107) on the second surface (118);
wherein the first printed circuit board (101) and the second printed circuit board (103) are brought together with their second surfaces (117, 118) in such a way that the first ends (111-1) of the contact pins (111) extend into the blind holes (109), and that the first electrical contacts (105) make electrical contact with the second electrical contacts (107).

2. The printed circuit board assembly (100) according to claim 1, wherein the first electrical contacts (105) are firmly electrically connected with the second electrical contacts (107), in particular soldered.

3. The printed circuit board assembly (100) according to claim 2, wherein the soldered connections between the first electrical contacts (105) and the second electrical contacts (107) provide an electrical connection and a structural connection of the first and second printed circuit boards (101, 103).

4. The printed circuit board assembly (100) according to one of the preceding claims, wherein the first electrical contacts (105) are formed as contact recesses, in particular solder cups, which are suitable for receiving a solder.

5. The printed circuit board assembly (100) according to one of the preceding claims, wherein the second electrical contacts (107) are formed as contact surfaces, in particular soldered pads, to which a solder is applyable.

6. The printed circuit board assembly (100) according to one of the preceding claims, wherein the plurality of first electrical connections (211-1) is formed as a plurality of through holes, in particular a plurality of soldered eyes, and is suitable for receiving and electrically connecting a plurality of components, in particular the contact pins (111).

7. The printed circuit board assembly (100) according to one of the preceding claims, wherein the position of the plurality of blind holes (109) on the second surface (118) of the second printed circuit board (103) corresponds to the position of the plurality of first electrical connections (211-1) on the second surface (117) of the first printed circuit board (101).

8. The printed circuit board assembly (100) according to one of the preceding claims, wherein the plurality of blind holes (109) is formed from an electrically insulating material.

9. The printed circuit board assembly (100) according to one of the preceding claims, wherein the second printed circuit board (103) comprises a plurality of second electrical connections (213-1), which are formed to receive and electrically connect a plurality of components, in particular a pin header (113) for system cabling.

10. The printed circuit board assembly (100) according to one of the preceding claims, wherein the first and second surfaces (115, 116, 117, 118) of the first and second printed circuit boards (101, 103) are surfaces of the printed circuit boards, which have the largest surface area.

11. The printed circuit board assembly (100) according to one of the preceding claims, wherein the first electrical contacts (105) of the first printed circuit board (101) and the second electrical contacts (107) of the second printed circuit board (103) are arranged congruently to one another.

12. The printed circuit board assembly (100) according to one of the preceding claims, wherein the first electrical contacts (105) are formed on an edge of the second surface (117) of the first printed circuit board (101) and the second electrical contacts (107) are formed on an edge of the second surface (118) of the second printed circuit board (103).

13. The printed circuit board assembly (100) according to one of the preceding claims, wherein the first printed circuit board (101) and the second printed circuit board (103) are brought together for electrical connection in such a way that the second surfaces (117, 118) of the first and second printed circuit boards (101, 103) lie on top of each other.

14. The printed circuit board assembly (100) according to one of the preceding claims, wherein the first printed circuit board (101) and the second printed circuit board (103) are arranged congruently to one another.

15. The printed circuit board assembly (100) according to one of the preceding claims, wherein the vertical dimensions of the printed circuit board assembly are determined by thicknesses of the first and second printed circuit boards (101, 103).

## Revendications

1. Ensemble de carte de circuits imprimés (100), comprenant :
une première carte de circuits imprimés (101) pourvue d'une première surface (115) et d'une deuxième surface (117) détournée de la première surface (115), d'une pluralité de broches de contact électriques (111) qui est reçue par une pluralité de premières connexions électriques (211-1) et qui traverse la première carte de circuits imprimés (101), des premières extrémités (111-1) des broches de contact (111) sur la deuxième surface (117) étant mises en contact électrique par des perles de soudure, ainsi qu'avec des premiers contacts électriques (105) qui sont disposés sur la deuxième surface (117) ; et
une deuxième carte de circuits imprimés (103) pourvue d'une première surface (116) et d'une deuxième surface (118) détournée de la première surface (116),
**caractérisé en ce que** dans la deuxième surface (118), une pluralité de trous borgnes (109) est formée pour recevoir les premières extrémités (111-1) des broches de contact (111), la deuxième carte de circuits imprimés (103) présentant sur la deuxième surface (118) des deuxièmes contacts électriques (107) ;
la première carte de circuits imprimés (101) et la deuxième carte de circuits imprimés (103) étant assemblées par leurs deuxièmes surfaces (117, 118) de telle sorte que les premières extrémités (111-1) des broches de contact (111) rentrent dans les trous borgnes (109) et que les premiers contacts électriques (105) entrent en contact électrique avec les deuxièmes contacts électriques (107).

2. Ensemble de carte de circuits imprimés (100) selon la revendication 1, dans lequel les premiers contacts électriques (105) sont reliés solidement électriquement aux deuxièmes contacts électriques (107), en particulier soudés.

3. Ensemble de carte de circuits imprimés (100) selon la revendication 2, dans lequel les liaisons soudées entre les premiers contacts électriques (105) et les deuxièmes contacts électriques (107) fournissent une liaison électrique et une liaison structurelle de la première et de la deuxième carte de circuits imprimés (101, 103).

4. Ensemble de carte de circuits imprimés (100) selon l'une quelconque des revendications précédentes, dans lequel les premiers contacts électriques (105) sont réalisés sous forme d'évidements de contact, en particulier de coupelles à souder, qui sont aptes à recevoir un métal d'apport.

5. Ensemble de carte de circuits imprimés (100) selon l'une quelconque des revendications précédentes, dans lequel les deuxièmes contacts électriques (107) sont réalisés sous forme de surfaces de contact, en particulier de plages de soudure, auxquelles un métal d'apport peut être appliqué.

6. Ensemble de carte de circuits imprimés (100) selon l'une quelconque des revendications précédentes, dans lequel la pluralité de premières connexions électriques (211-1) est réalisée sous la forme d'une pluralité de trous traversants, en particulier d'une pluralité de pastilles de soudure, et est apte à recevoir et à relier électriquement une pluralité de composants, en particulier les broches de contact (111).

7. Ensemble de carte de circuits imprimés (100) selon l'une quelconque des revendications précédentes, dans lequel la position de la pluralité de trous borgnes (109) sur la deuxième surface (118) de la deuxième carte de circuits imprimés (103) correspond à la position de la pluralité de premières connexions électriques (211-1) sur la deuxième surface (117) de la première carte de circuits imprimés (101).

8. Ensemble de carte de circuits imprimés (100) selon l'une quelconque des revendications précédentes, dans lequel la pluralité de trous borgnes (109) est réalisée dans un matériau électriquement isolant.

9. Ensemble de carte de circuits imprimés (100) selon l'une quelconque des revendications précédentes, dans lequel la deuxième carte de circuits imprimés (103) présente une pluralité de deuxièmes connexions électriques (213-1) qui est réalisée pour recevoir et relier électriquement une pluralité de composants, en particulier une barrette à broches (113) destinée au câblage du système.

10. Ensemble de carte de circuits imprimés (100) selon l'une quelconque des revendications précédentes, dans lequel la première et la deuxième surface (115, 116, 117, 118) de la première et de la deuxième carte de circuits imprimés (101, 103) sont les surfaces des cartes de circuits imprimés qui présentent la plus grande superficie.

11. Ensemble de carte de circuits imprimés (100) selon l'une quelconque des revendications précédentes, dans lequel les premiers contacts électriques (105) de la première carte de circuits imprimés (101) et les deuxièmes contacts électriques (107) de la deuxième carte de circuits imprimés (103) sont disposés de manière coïncidente les uns avec les autres.

12. Ensemble de carte de circuits imprimés (100) selon l'une quelconque des revendications précédentes, dans lequel les premiers contacts électriques (105) sont réalisés au bord de la deuxième surface (117) de la première carte de circuits imprimés (101) et les deuxièmes contacts électriques (107) sont réalisés au bord de la deuxième surface (118) de la deuxième carte de circuits imprimés (103).

13. Ensemble de carte de circuits imprimés (100) selon l'une quelconque des revendications précédentes, dans lequel la première carte de circuits imprimés (101) et la deuxième carte de circuits imprimés (103) sont assemblées pour une liaison électrique de telle sorte que les deuxièmes surfaces (117, 118) de la première et de la deuxième carte de circuits imprimés (101, 103) reposent l'une sur l'autre.

14. Ensemble de carte de circuits imprimés (100) selon l'une quelconque des revendications précédentes, dans lequel la première carte de circuits imprimés (101) et la deuxième carte de circuits imprimés (103) sont disposées de manière coïncidente l'une avec l'autre.

15. Ensemble de carte de circuits imprimés (100) selon l'une quelconque des revendications précédentes, dans lequel les dimensions verticales de l'ensemble de carte de circuits imprimés sont déterminées par les épaisseurs de la première et de la deuxième carte de circuits imprimés (101, 103).
